# EUROPÄISCHE PATENTSCHRIFT

(11) **EP 1 586 129 B1**
(45) Veröffentlichungstag und Bekanntmachung des Hinweises auf die Patenterteilung: **18.04.2007**
(21) Anmeldenummer: 04701945.0
(22) Anmeldetag: 14.01.2004
(51) Int. Cl.: H01L 51/30

(54) **VERWENDUNG LEITFÄHIGER CARBON-BLACK/GRAPHIT-MISCHUNGEN FÜR DIE HERSTELLUNG VON LOW-COST ELEKTRONIK**
USE OF CONDUCTIVE CARBON BLACK/GRAPHITE MIXTURES FOR THE PRODUCTION OF LOW-COST ELECTRONICS
UTILISATION DE MELANGES DE NOIR DE CARBONE/GRAPHITE POUR LA PRODUCTION DE DISPOSITIFS ELECTRONIQUES A BAS PRIX

(30) Priorität: 21.01.2003 DE 10302149
(43) Veröffentlichungstag der Anmeldung: 19.10.2005
(73) Patentinhaber: PolyIC GmbH & Co. KG, 90763 Fürth (DE)
(72) Erfinder: BERNDS, Adolf, 91083 Baiersdorf (DE); KNOBLOCH, Alexander, Friedrich, 91233 Neukirchen (DE); ROST, Henning, 91056 Erlangen (DE)
(74) Vertreter: Zinsinger, Norbert
(86) Internationale Anmeldenummer: PCT/EP2004/000214
(87) Internationale Veröffentlichungsnummer: WO 2004/066411

(56) Entgegenhaltungen:
- WO-A-01/06442
- GB-A- 723 598
- US-A- 4 442 019

## Beschreibung

Die Erfindung betrifft leitfähige Polymerlösungen, die zur Herstellung von organischen Elektronikbauelementen einsetzbar sind. In GB 723 598 wird z.B. die Herstellung elektrisch leitender Plastik - Formteile durch Beimmengung von Graphit beschrieben.

Die Herstellung von low-cost Polymerelektronik durch Drucken wird kontinuierlich in Anlehnung an konventionelle Techniken, wie sie beispielsweise in der Graphik eingesetzt werden, weiterentwickelt. Dabei ergeben sich jedoch wesentliche Nachteile, zum einen kann nur eine drastisch erhöhte Auflösung-der Strukturen zu Mikroelektronischen Bauteilen führen und zum anderen wird eine Schichtqualität gefordert, die die elektrischen Kontakte und Leiterbahnen überhaupt erst ermöglicht.

Dazu werden druckbare Tinten entwickelt, in denen die leitfähigen Polymere gut löslich sind, wobei diese Substanzen wegen ihrer rheologischen Eigenschaften wie Viskosität, Adhäsion und Benetzungsverhalten nur in engen Grenzen löslich sind und damit gedruckt noch nicht den Anforderungen genügen, die an die Struktur und Schichtqualität gestellt werden.

Bekannt sind Polymerlösungen, die durch Zugabe von Ruß (Carbon-Black) oder Graphit leitfähig gemacht werden. Bekannt ist auch eine Mischung von Ruß- und Graphitteilchen. Hier wird beschrieben, wie diese Mischungen vorteilhaft für den Aufbau von organischen Schaltungen eingesetzt werden können. Zu diesen Mischungen kann man natürlich noch andere Materialien zugeben, die die Funktionalität der Schichten verbessern, beispielsweise Pani oder Pedot.

Bei den Carbon Black/Graphit gefüllten Polymerlösungen gibt es in dieser Hinsicht weniger Probleme, weil diese in Lösung in einem größeren Konzentrationsbereich variabel druckbar sind als die reinen Polymerlösungen. Dennoch werden diese Lösungen nicht für das Drucken von Polymerelektronik eingesetzt, weil die harten Partikel der Carbon-Black/Graphit-Polymerlösungen lokale Beschädigungen des mikroelektronischen Bauteils und/oder der Druckmaschinen verursachen.

Aufgabe der vorliegenden Erfindung ist es, die Partikel der Carbon-Black/Graphit Partikel in den polymeren Lösungen derart zu modifizieren, dass sich Lösungen ergeben, die weder Beschädigungen an den Bauteilen noch an den Druckmaschinen hervorrufen.

Gegenstand der Erfindung ist die Verwendung einer mit Carbon-Black/Graphit gefüllten Polymerlösung, in der die Carbon-Black/Graphit-Partikel im wesentlichen in Form von Mikroplättchen vorliegen, zur Herstellung elektronischer Bauelemente.

Ausgestaltungen der Erfindungen gehen aus den Unteransprüchen hervor.

Bevorzugt dient die Verwendung zum Aufbau organischer Elektronik-Bauteile, wie z.B. organischer Transistoren und Schaltungen hieraus, organischer Dioden, organisch basierter Kondensatoren, organischer Photovoltaik-Zellen, organischer Sensoren und Aktoren, sowie Kombinationen hieraus.

Nach einer Ausführungsform werden Mikroplättchen eingesetzt, die in spitzenloser Form vorliegen.

Nach einer Ausführungsform der Erfindung werden Polymerlösungen eingesetzt, die einen Feststoffgehalt von 15 bis 60 Gew%, insbesondere von 20 bis 45 Gew%, insbesondere bevorzugt von 34,5 bis 41 Gew%.

Die Viskosität der verwendeten Lösungen kann stark variieren, es können sowohl Harze (Viskositäten zwischen 20.000-40.000mPa.s) als auch Flüssigkeiten (Viskositäten zwischen 800-3600 mPa.s) eingesetzt werden, wobei der Begriff "Lösung" sich nur darauf bezieht, dass eine Komponente in einer anderen gelöst vorliegt. Die hier in Rede stehenden Polymerlösungen können beispielsweise flüssig, gelartig, fest oder harzig sein, wobei die Zugabe der Carbon-Black/Graphit-Partikel nochmal einen Einfluss auf die Viskosität hat.

Die Wahl des Lösungsmittels richtet sich nach den Druck- und/oder Trocknungseigenschaften die erreicht werden sollen.

Die Polymerlösungen mit Mikroplättchen haben gute Eignung für den Einsatz in der low-cost Mikroelektronik erwiesen. Der Vorteil der Polymerlösungen besteht darin, dass sie bei zufriedenstellender elektrischer Funktion im Mikroelektronik-Bauteil eine gute Prozessierbarkeit, speziell im Druckverhalten mit breiter Variabilität der Konzentration der Carbon-Black/Graphit Partikel kombinieren.

Bevorzugt werden Carbon-Black/Graphit gefüllte Polymerlösungen eingesetzt, die von der Firma Acheson Colloids Company (www.achesonindustries.com) für medizinische Elektroden, Batterieüberzüge, Kautschukharze und ähnliches entwickelt wurden.

Aus der Produktpalette der Acheson Materialien wurde der Typ "Electrodag ® PF-407A" eine bekannte Siebdruckmasse, die nicht für die Anwendung im Mikroelektronikbereich konzipiert ist, zum Tampondruck von Vias und Gate-Elektroden eingesetzt. Das Material zeigte sich stabil und funktionell in einzelnen Polmer Feld-Effekt-Transistoren bis hin zu Ringoszillator-Schaltkreisen.

Weiterhin wurden mit "Elektrodag ® 109" aussichtsreiche Tiefdruckversuche für Source/Drain Elektroden vorgenommen.

Die Erfindung offenbart druckfertige Polymerlösungen, die zur Herstellung polymerer Mikroelektronikbauteile eingesetzt werden können.

## Patentansprüche

1. Verwendung einer mit Carbon-Black/Graphit gefüllten Polymerlösung, in der die Carbon-Black/Graphit-Partikel im wesentlichen in Form von Mikroplättchen vorliegen, zur Herstellung eines elektronischen Bauelements.

2. Verwendung nach Anspruch 1, wobei die Polymerlösung noch Zusätze wie PEDOT und/oder PANI enthält.

3. Verwendung nach Anspruch 1 oder 2, wobei die Herstellung des elektronischen Bauelements zumindest einen Druckarbeitsschritt umfasst.

4. Verwendung nach einem der Ansprüche 1 bis 3 zum Aufbau organischer Elektronik-Bauteile, wie z.B. organische Transistoren und Schaltungen hieraus, organische Dioden, organisch basierte Kondensatoren, organische Photovoltaik-Zellen, organische Sensoren und Aktoren, sowie Kombinationen hieraus.

5. Verwendung nach einem der vorstehenden Ansprüche, wobei der Feststoffgehalt der Carbon-Black/Graphit-Partikel in der Lösung zwischen 15 und 60 Gew% ausmacht.

6. Verwendung nach einem der vorstehenden Ansprüche, wobei die Carbon-Black/Graphit-Partikel in spitzenloser Form als Mikroplättchen vorliegen.

## Claims

1. Use of a polymer solution which is filled with carbon black/graphite and in which the carbon black/graphite particles are essentially present in the form of microplatelets, for the production of an electronic component.

2. Use according to Claim 1, wherein the polymer solution additionally contains additives such as PEDOT and/or PANI.

3. Use according to Claim 1 or 2, wherein the production of the electronic component comprises at least one printing operation.

4. Use according to any one of Claims 1 to 3 for construction of organic electronic components, for example organic transistors and circuits therefrom, organic diodes, organic-based capacitors, organic photovoltaic cells, organic sensors and actuators, and also combinations thereof.

5. Use according to any one of the preceding claims, wherein the solids content of the carbon black/graphite particles in the solution is between 15% and 60% by weight.

6. Use according to any one of the preceding claims, wherein the carbon black/graphite particles are present as microplatelets in point-free form.

## Revendications

1. Utilisation d'une solution polymère remplie de noir de carbone/graphite, dans laquelle les particules de noir de carbone/graphite sont présentes essentiellement sous la forme de microplaquettes, pour la fabrication d'un composant électronique.

2. Utilisation selon la revendication 1, la solution polymère contenant également des additifs comme PEDOT et/ou PANI.

3. Utilisation selon la revendication 1 ou 2, la fabrication du composant électronique comprenant au moins une étape de travail d'impression.

4. Utilisation selon l'une quelconque des revendications 1 à 3 pour la constitution de composants d'électronique organiques, comme par exemple des transistors organiques et des circuits à base de ces transistors, des diodes organiques, des condensateurs à base organique, des cellules photovoltaïques organiques, des capteurs et des acteurs organiques, ainsi que des combinaisons de ces éléments.

5. Utilisation selon l'une quelconque des revendications précédentes, la teneur en matières solides des particules de noir de carbone/graphite représentant entre 15 et 60 % en poids dans la solution.

6. Utilisation selon l'une quelconque des revendications précédentes, les particules de noir de carbone/graphite étant présentes dans une forme sans pointe sous la forme de microplaquettes.
